# EUROPEAN PATENT APPLICATION

(11) **EP 4 020 577 A1**
(43) Date of publication of application: **29.06.2022**
(21) Application number: 20881061.4
(22) Date of filing: 21.10.2020
(51) Int. Cl.: H01L 27/32, G09F 9/33

(54) **DISPLAY APPARATUS AND ELECTRONIC DEVICE**

(30) Priority: 31.10.2019 CN 201911049783
(71) Applicant: GUANGDONG OPPO MOBILE TELECOMMUNICATIONS CORP., LTD., Dongguan, Guangdong 523860 (CN)
(72) Inventor: YANG, Xin, Dongguan, Guangdong 523860 (CN)
(74) Representative: Thorniley, Peter
(86) International application number: PCT/CN2020/122419
(87) International publication number: WO 2021/082999

(57) **Abstract**

Provided in the embodiments of the present application are a display apparatus and an electronic device, the display apparatus comprising a first display area and a second display area; the first display area comprises a first common electrode layer, a first light-emitting layer, and an auxiliary electrically conductive part; the auxiliary electrically conductive part is arranged on the side of the first common electrode layer facing away from the first light-emitting layer, the first light-emitting layer comprises a plurality of first pixels, the orthographic projection of the auxiliary electrically conductive part on the light-emitting layer is positioned between the plurality of first pixels, and the auxiliary electrically conductive part is electrically connected to the first common electrode layer.

## Description

This application claims priority of Chinese patent applications No. 201911049783.1 filed October 31, 2019, entitled "DISPLAY APPARATUS AND ELECTRONIC DEVICE", the contents of which are incorporated herein by reference in their entirety.

### TECHNICAL FIELD

The present disclosure relates to the field of electronic technology, and more particularly, to a display device and an electronic device.

### BACKGROUND

With developments of communication technology, electronic devices such as smart phones are becoming more and more popular. During uses of the electronic device, the electronic device can use its display screen to display images.

In order to have better display effects and user experiences, a size of a display screen is getting larger and larger, but it is difficult to hold the display screen of an electronic device when it exceeds a certain size, so it is more and more important to increase a screen-to-body ratio of the display screen. In the related art, a camera is set on a back of the display of the display device, and the display device is provided with a light transmission channel corresponding to the camera. The camera is used to form images by obtaining external light signal through the light transmission channel. The light transmission channel is small in size and can increase the screen-to-body ratio of the display device. However, the light transmission channel cannot display images, which makes a display area of the display device incomplete.

### SUMMARY

Embodiments of the present application provide a display device and electronic device, which can increase a screen-to-body ratio of the display device and complete a display area of the display device.

An embodiment of the present application provides a display device, and the display device comprises:
a first display area, wherein the first display area comprises a first common electrode layer and a first light-emitting layer, and the first common electrode layer covers the first light-emitting layer; and
a second display area, wherein the second display area comprises a second common electrode layer and a second light-emitting layer, the second common electrode layer covers the second light-emitting layer, and a thickness of the second common electrode layer is greater than a thickness of the first common electrode;
wherein the first display area further comprises an auxiliary conductive portion, the auxiliary conductive portion is disposed on a side of the first common electrode layer away from the first light-emitting layer, the first light-emitting layer comprises a plurality of first pixels, an orthographic projection of the auxiliary conductive portion on the light-emitting layer is located between the plurality of first pixels, and the auxiliary conductive portion is electrically connected to the first common electrode layer.

An embodiment of the present application further provides a display device, and the display device comprises:
a first display area, wherein the first display area comprises a first light-emitting layer and a first common electrode layer that are stacked, the first light-emitting layer comprises a plurality of first pixels, the first common electrode layer comprises an auxiliary conductive portion and a plurality of first conductive blocks, the auxiliary conductive portion has a plurality of openings corresponding to the plurality of first pixels, each of the openings is provided with the first conductive block, each of the first conductive blocks is adjacent to the first pixel, and the auxiliary conductive portion is electrically connected to a plurality of the first conductive blocks; and
a second display area, wherein the second display area comprises a second light-emitting layer and a second common electrode layer, the second light-emitting layer comprises a plurality of second pixels, the second common electrode layer comprises a plurality of second conductive blocks, each of the second conductive blocks is adjacent to a second pixel, the plurality of the second conductive blocks are electrically connected, and a thickness of the second conductive blocks is greater than a thickness of the first conductive blocks.

An embodiment of the present application further provides an electronic device, and the electronic device comprises:
a display device, wherein the display device is any one of the above display devices; and
a camera, wherein the camera comprises a lens, the lens is disposed toward the first display area, and the camera is used to form an image by obtaining an external light signal passing through the first display area.

### BRIEF DESCRIPTION OF THE DRAWINGS

In order to more clearly describe the technical solutions in the embodiments of the present application, the following will briefly introduce the drawings that need to be used in the description of the embodiments.
FIG. 1 is a first structural schematic diagram of an electronic device provided by an embodiment of this application.
FIG. 2 is a structural schematic diagram of a display device provided by an embodiment of the application.
FIG. 3 is a schematic diagram of a first partial stacking of a display device provided by an embodiment of the application.
FIG. 4 is a schematic diagram of a lamination of the first common electrode layer in the first display area of the display device provided by an embodiment of the application.
FIG. 5 is a schematic diagram of a second partial stacking of the display device provided by an embodiment of the application.
FIG. 6 is a schematic diagram of a third partial stacking of the display device provided by an embodiment of the application.
FIG. 7 is a stacking schematic diagram of the first display area of the display device provided by an embodiment of the application.
FIG. 8 is a schematic diagram of a portion of the structure of a display device provided by an embodiment of the application.
FIG. 9 is a schematic diagram of a pixel distribution in a portion X of the display device shown in FIG. 8.
FIG. 10 is a schematic diagram of a distribution of driving units of the portion X of the display device shown in FIG. 8.
FIG. 11 is a schematic circuit diagram of a first driving circuit in a display device provided by an embodiment of the application.
FIG. 12 is a structural schematic diagram of the first pixel in a first display area of a display device provided by an embodiment of the application.
FIG. 13 is another structural schematic diagram of an electronic device provided by an embodiment of the application.

### DETAILED DESCRIPTION OF THE ILLUSTRATED EMBODIMENTS

Embodiments of the present disclosure are described in detail below. Embodiments described below are exemplary, and are only used to explain the present disclosure, and should not be construed as limiting the present disclosure. Where specific techniques or conditions are not indicated in the examples, the procedures shall be carried out in accordance with the techniques or conditions described in the literature in the field or in accordance with the product specification.

An embodiment of the present application provides a display device, and the display device comprises:
a first display area, wherein the first display area comprises a first common electrode layer and a first light-emitting layer, and the first common electrode layer covers the first light-emitting layer; and
a second display area, wherein the second display area comprises a second common electrode layer and a second light-emitting layer, the second common electrode layer covers the second light-emitting layer, and a thickness of the second common electrode layer is greater than a thickness of the first common electrode;
wherein the first display area further comprises an auxiliary conductive portion, the auxiliary conductive portion is disposed on a side of the first common electrode layer away from the first light-emitting layer, the first light-emitting layer comprises a plurality of first pixels, an orthographic projection of the auxiliary conductive portion on the light-emitting layer is located between the plurality of first pixels, and the auxiliary conductive portion is electrically connected to the first common electrode layer.

A light transmittance of the auxiliary conductive portion is greater than a light transmittance of the first common electrode layer.

A thickness of the auxiliary conductive portion is greater than a thickness of the first common electrode layer; and/or a resistivity of the auxiliary conductive portion is less than a resistivity of the first common electrode layer.

The first common electrode layer includes at least a first metal layer, a second metal layer, and a third metal layer that are stacked, and a material of the first metal layer is different from a material of the second metal layer, and the material of the second metal layer is different from a material of the third metal layer.

The material of the first metal layer and the third metal layer is both metallic magnesium, and the material of the second metal layer is metallic silver.

The first common electrode layer and the auxiliary conductive portion have a first impedance per unit area after being electrically connected, the second common electrode layer has a second impedance per unit area, and the first impedance is less than or equal to the second impedance.

The display device further comprises a plurality of first driving units for driving the plurality of the first pixels, and at least some of the plurality of first driving units are disposed in the second display area.

The first display area comprises a plurality of first pixel sets, each of the first pixel sets comprises at least two of the first pixels connected in parallel with each other, and all the first pixels in each of the first pixel sets are electrically connected to the first driving unit.

The second display area comprises a first sub-display area and a second sub-display area, and the second sub-display area is connected to the first display area through the first sub-display area, a resolution of the first sub-display area is lower than a resolution of the second sub-display area.

A pixel density of the first sub-display area is less than a pixel density of the second sub-display area.

The first sub-display area comprises a plurality of second pixel sets and a plurality of second driving units, and each of the second pixel sets comprises at least two of the second pixels connected in parallel with each other, and all the second pixels in each of the second pixel sets are electrically connected to the second driving unit.

An embodiment of the present application further provides a display device, and the display device comprises:
a first display area, wherein the first display area comprises a first light-emitting layer and a first common electrode layer that are stacked, the first light-emitting layer comprises a plurality of first pixels, the first common electrode layer comprises an auxiliary conductive portion and a plurality of first conductive blocks, the auxiliary conductive portion has a plurality of openings corresponding to the plurality of first pixels, each of the openings is provided with the first conductive block, each of the first conductive blocks is adjacent to the first pixel, and the auxiliary conductive portion is electrically connected to a plurality of the first conductive blocks; and
a second display area, wherein the second display area comprises a second light-emitting layer and a second common electrode layer, the second light-emitting layer comprises a plurality of second pixels, the second common electrode layer comprises a plurality of second conductive blocks, each of the second conductive blocks is adjacent to a second pixel, the plurality of the second conductive blocks are electrically connected, and a thickness of the second conductive blocks is greater than a thickness of the first conductive blocks.

A light transmittance of the auxiliary conductive portion is greater than a light transmittance of the first conductive blocks.

A thickness of the auxiliary conductive portion is greater than a thickness of the first common electrode layer; and/or a resistivity of the auxiliary conductive portion is less than a resistivity of the first conductive blocks.

An impedance per unit area of the first common electrode layer is less than or equal to an impedance per unit area of the second impedance.

The first light-emitting layer further comprises a first pixel definition layer, the first pixel definition layer has a plurality of pixel holes, and each pixel hole is provided with the first pixel, and the first conductive block is arranged in the pixel hole and covers the first pixel.

The auxiliary conductive portion is adjacent to the first pixel defining layer, the auxiliary conductive portion has a first surface adjacent to the first pixel defining layer, and a surface of the block facing away from the first pixel is level with the first surface.

The display device further comprises a plurality of first driving units for driving the plurality of the first pixels, and at least some of the plurality of first driving units are at disposed in the second display area.

The first display area comprises a plurality of first pixel sets, each of the first pixel sets comprises at least two of the first pixels connected in parallel with each other, and all the first pixels in each of the first pixel sets are electrically connected to the first driving unit.

The second display area comprises a first sub-display area and a second sub-display area, and the second sub-display area is connected to the first display area through the first sub-display area, a resolution of the first sub-display area is lower than a resolution of the second sub-display area.

An embodiment of the present application further provides an electronic device, and the electronic device comprises:
a display device, wherein the display device is any one of the above display devices; and
a camera, wherein the camera comprises a lens, the lens is disposed toward the first display area, and the camera is used to form an image by obtaining an external light signal passing through the first display area.

Embodiments of the present application provide an electronic device and a display device thereof. The electronic device may include a display device and a camera. The lens of the camera is set relative to the display device, that is, the camera acquires external light signals passing through the display device for imaging. It can be understood that the light transmittance of the conventional display device is low, and the effect of the camera through the display device for imaging is not good. For this reason, the embodiment of the present application may set the display device in zones, for example, setting the light transmittance of the portion of the display device corresponding to the camera to be greater than the light transmittance of other positions of the display device, which can improve the imaging effect of the camera. The technical solutions in the embodiments of the present application will be clearly and completely described below in conjunction with the drawings in the embodiments of the present application.

Electronic devices provided by embodiments of the application can be mobile terminal devices such as mobile phones and tablet computers, and can also be gaming devices, augmented reality (AR) devices, virtual reality (VR) devices, on-board computers, laptop computers, data storage devices, audio playback devices, video playback devices, wearable devices and other devices with display devices, wherein the wearable devices can be smart bracelets, smart glasses, etc.

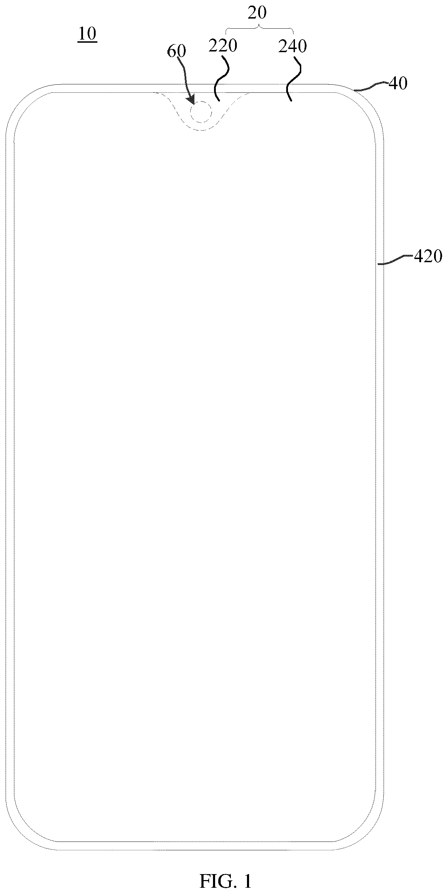

Please refer to FIG. 1, FIG. 1 is a first structural schematic diagram of an electronic device provided by an embodiment of this application. FIG. 1 shows an example in which the electronic device is a mobile phone, wherein the display device 20 comprises a first display area 220 and a second display area 240, and a light transmittance of the first display area 220 is greater than a light transmittance of the second display area 240. The electronic device 10 is provided with a sensor, and the sensor is used to transmit a signal through the first display area 220. For example, the sensor is a camera 60, a lens of the camera 60 is set toward the first display area 220, and the camera 60 is used to form images by obtaining an external light signal passing through the first display area 220. It can also be understood that the camera 60 is disposed under the first display area 220 of the display device 20, and the camera 60 is used to obtain an external light signal passing through the first display area 220 of the display device 20, and to form images according to the obtained external light signal. A side of the display device 20 facing the outside can be basically a display surface, that is, the display surface of the first display area 220 and the display surface of the second display area 240 can occupy the entire front of the display device 20, or it can be understood that the electronic device 10 is a full-screen device, and the display area of the display device 20 is complete, which increases a screen-to-body ratio of the electronic device 10. For example, the camera 60 can be used as a front camera of an electronic device, and the camera 60 can be used to obtain images such as a user's selfie through the first display area 220 of the display device 20. It can be understood that the sensor may be at least one of a camera, a proximity sensor, a light sensor, a distance measuring sensor, a fingerprint recognition sensor, and the like.

In order to have a more understanding of the display device in the embodiment of the present application. The display device will be described in detail below.

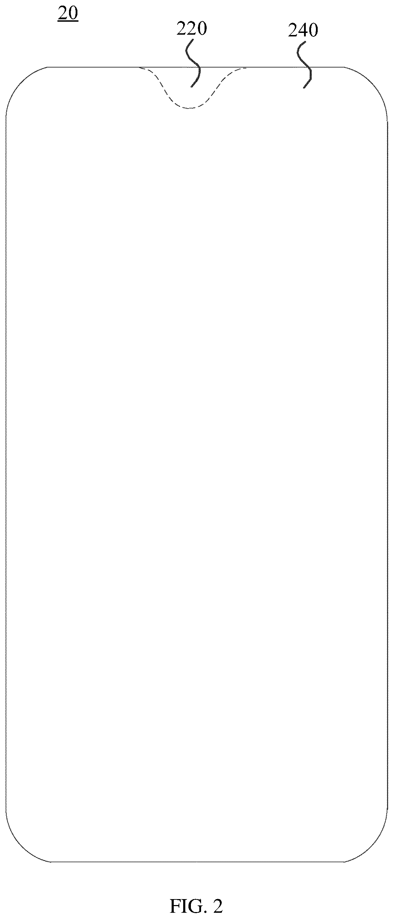

Please refer to FIG. 2, which is a first structural schematic diagram of a display device provided by an embodiment of the application. The display device 20 in the embodiment of the present application may comprise a first display area 220 and a second display area 240 that are adjacent to each other. Both the first display area 220 and the second display area 240 can be used to display text or images, and the first display area 220 and the second display area 240 can display the same image together. For example, the second display area 240 displays a portion of a preset image, and the first display area 220 displays the remaining portion of the preset image. The first display area 220 and the second display area 240 may also display different images. For example, the second display area 240 displays a preset image, and the first display area 220 displays a task bar image. Both the first display area 220 and the second display area 240 can display contents, the display area is complete, and the screen-to-body ratio of the display device 20 is high. The second display area 240 may be arranged around the first display area 220, and a periphery of the first display area 220 may be adjacent to the second display area 240, that is, the first display area 220 is located in the middle of the second display area 240. The second display area 240 may also partially surround the first display area 220, and a portion of an edge of the first display area 220 is adjacent to the second display area 240. For example, the first display area 220 is located at a corner of the display device 20 or is located in the top middle the display device 20.

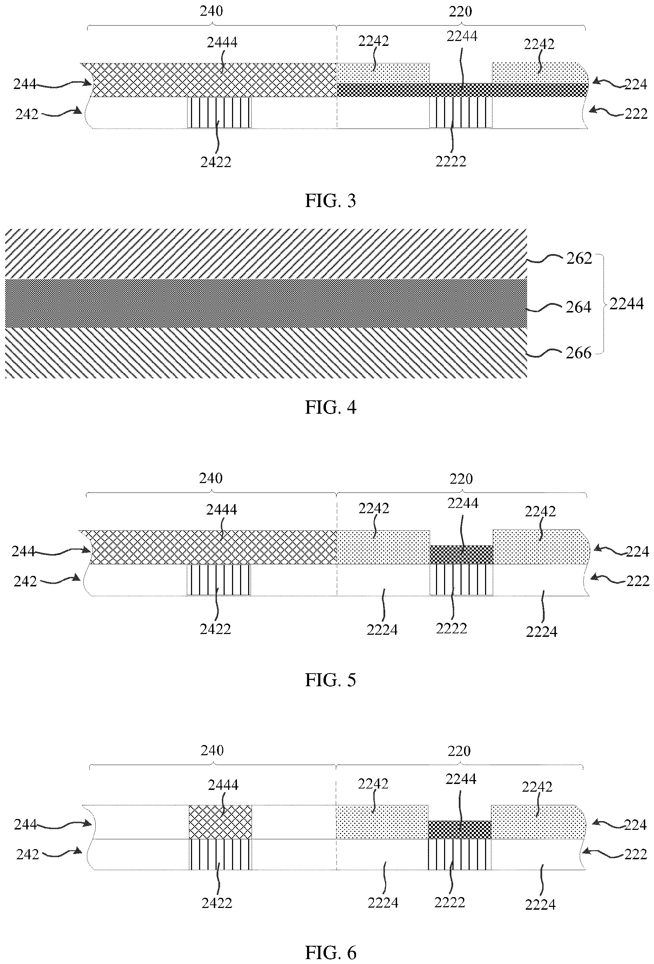

Please refer to FIG. 3. FIG. 3 is a schematic diagram of a first partial stacking structure of the display device according to an embodiment of the present application. The first display area 220 comprises a first common electrode layer 224 and a first light-emitting layer 222, and the first common electrode layer 224 covers the first light-emitting layer 222. The first light-emitting layer 222 comprises a plurality of first pixels 2222. The second display area 240 comprises a second common electrode layer 244 and a second light emitting layer 242, the second common electrode layer 244 covers the second light emitting layer 242, and a thickness of the second common electrode layer 244 is greater than a thickness of the first common electrode layer 224.

The thickness of the first common electrode layer 224 is less than the thickness of the second common electrode layer 244, and the light transmittance of the first common electrode layer 224 is greater than the light transmittance of the second common electrode layer 244, which can increase the light transmittance of the first display area. However, an impedance (resistance) of the first common electrode layer 224 will be greater than an impedance of the second common electrode layer 244, which will cause a greater voltage drop than that of the second common electrode layer 244. The larger the voltage drop is, the voltage drop of the first common electrode layer between the first light-emitting layer and the first pixel will also be large. An actual driving voltage of the first pixel deviates from the driving voltage that is really needed, and the actual display effect deviates from the expected is larger.

The impedance of the first common electrode layer driving the first pixel can be reduced by adding auxiliary conductive portions. Specifically, the first display area 220 may further comprise an auxiliary conductive portion 2242. The auxiliary conductive portion 2242 is disposed on a side of the first common electrode layer 224 away from the first light-emitting layer 222. An orthographic projection of the auxiliary conductive portion 2242 on the of the first light-emitting layer 222 is located between the plurality of first pixels 2222, and the auxiliary conductive portion 2242 is electrically connected to the first common electrode layer 224. The auxiliary conductive portion 2242 is arranged corresponding to the interval between the first pixels 2222. The auxiliary conductive portion 2242 is combined with the first common electrode layer 224 to reduce an overall impedance of the two, so that the impedance after combining the first common electrode layer 224 and the auxiliary conductive portion 2242 is controlled within an acceptable range. For example, the impedance per unit area after the first common electrode layer 224 and the auxiliary conductive portion 2242 are combined is approximately equal to the impedance per unit area of the second common electrode layer 244. Even after the first common electrode layer 224 is separated by a certain distance, because the auxiliary conductive portion does not have a large voltage difference, the voltage difference between the first common electrode layer of the first light-emitting layer and the first pixel is very small. The driving voltage is equal to or similar to the actual driving voltage required, and the actual display effect is consistent with the expectation. In addition, the first common electrode layer 224 covers the entire layer of the first display area 220, and the second common electrode layer 244 covers the entire layer of the second display area 240, which facilitates the production of the first common electrode layer 224 and the second common electrode layer 244. An auxiliary conductive portion 2242 is added to the first common electrode layer 224 to facilitate electrical connection between the two, and the contact area between the two is large, and the contact performance is good and stable.

Herein, the first common electrode layer 224 needs to cooperate with other components in the area to drive the first pixel 2222, and the auxiliary conductive portion 2242 is used to electrically connect the first common electrode layer 224 and reduce the overall impedance after the electrically connecting the first common electrode layer 224 and the auxiliary conductive portion. In some embodiments, a material of the auxiliary conductive portion 2242 of a light transmittance greater than that of the first common electrode layer 224 can be selected, so that the light transmittance of the auxiliary conductive portion 2242 is greater than that of the first common electrode layer 224 of the same thickness. At the same time, the light transmittances of the auxiliary conductive portion 2242 and the first common electrode layer 224 are both greater than the light transmittance of the second common electrode layer 244. In this way, the light transmittance of the first common electrode layer 224 can be made greater than the light transmittance of the second common electrode layer 244. For example, the material of the first common electrode layer 224 is magnesium metal or silver metal. The auxiliary conductive portion 2242 can be selected from transparent conductive materials such as indium tin oxide (ITO).

Herein, the first common electrode layer 224 can be formed by sputtering ultra-thin metal. For example, the first common electrode layer 224 is obtained by sputtering ultra-thin metallic magnesium or metallic silver.

Please refer to FIG. 4, which is a schematic diagram of the stacking of the first common electrode layer in the first display area of the display device according to an embodiment of the application. The first common electrode layer 224 may have a multilayer structure. For example, the first common electrode layer 224 comprises at least a first metal layer 262, a second metal layer 264, and a third metal layer 266 that are stacked, and the material of the first metal layer 262 and the material of the second metal layer 264 are different. The material of the second metal layer 264 and the material of the third metal layer 266 are different. For example, the materials of the first metal layer 262 and the third metal layer 266 are both magnesium metal, and the material of the second metal layer 264 is silver metal. Not only can the conductivity of the first common electrode layer 224 can be ensured, but also a better light transmittance can be achieved, and the cost can be reduced. The first common electrode layer 224 may also adopt other laminated structures. For example, the materials of the first metal layer 262 and the third metal layer 266 are both metallic silvers, and the material of the second metal layer 264 is metallic magnesium. It should be noted that the first common electrode layer 224 may also have a single-layer structure, a two-layer structure, a four-layer structure, or the like. In addition, the first conductive block can also be obtained by disposing indium zinc oxide on the first light-emitting layer.

The auxiliary conductive portion connected to the first common electrode layer can be used to reduce the overall impedance after the first common electrode layer and the auxiliary conductive portion are electrically connected. Therefore, the lower the impedance of the auxiliary conductive portion is the better. Herein, a material with a resistivity lower than that of the first common electrode layer can be selected to form the auxiliary conductive portion, that is, the resistivity of the auxiliary conductive portion is lower than that of the first common electrode layer, and the resistivity of the material of the auxiliary conductive portion itself is lower than that of the first common electrode. The resistivity of the material of the layer can reduce the impedance of the auxiliary conductive portion, and reduce the overall impedance after the first common electrode layer and the auxiliary conductive portion are electrically connected. Herein, the thickness of the auxiliary conductive portion may be the same as or different from the thickness of the first conductive block.

It is also possible to reduce the impedance of the auxiliary conductive portion by increasing a volume of the auxiliary conductive portion. It is difficult to increase the surface area of the auxiliary conductive portion. The volume of the auxiliary conductive portion can be increased by increasing the thickness of the auxiliary conductive portion, that is, the thickness of the auxiliary conductive portion is greater than the thickness of the first common electrode layer, thereby reducing the impedance of the auxiliary conductive portion, and reduce the overall impedance after the first common electrode layer and the auxiliary conductive portion are electrically connected. Herein, the resistivity of the auxiliary conductive portion may be the same as or different from the resistivity of the first common electrode layer.

It should be noted that in order to reduce the impedance of the auxiliary conductive portion, a material with a smaller resistivity can be selected while increasing the thickness of the auxiliary conductive portion. That is, the resistivity of the auxiliary conductive portion may be less than the resistivity of the first common electrode layer, while the thickness of the auxiliary conductive portion is greater than the thickness of the first common electrode layer. On the basis of not changing the impedance of the first common electrode layer, by reducing the impedance of the auxiliary conductive portion, the overall impedance after the first common electrode layer and the auxiliary conductive portion are electrically connected is reduced as much as possible.

By electrically connecting the auxiliary conductive portion is to the first common electrode layer, the impedance per unit area of the first common electrode layer is controlled within an acceptable range, and it is approximately equal to the impedance per unit area of the second common electrode layer. The voltage drop per unit distance is the same as or similar to that of the second common electrode layer, the driving voltage of the first pixel in the first display area and the second pixel in the second display area are not much different. The impedance per unit area of the first common electrode layer and the second common electrode layer will not be different due to the thickness of the first common electrode layer is less than that of the second common electrode layer, which results in different driving voltages of the two.

It should be noted that the sum of the thickness of the auxiliary conductive portion and the first common electrode layer may be the same as the thickness of the second common electrode layer, or may be greater than the thickness of the second common electrode layer.

The first display area may comprise a stacked substrate, a driving circuit layer, an anode layer, a first light-emitting layer, a first common electrode layer, a planarization layer, and the like. Herein, the driving circuit layer, the anode layer and the first common electrode layer jointly drive the first pixel in the first light-emitting layer to emit light and display. The second display area has a layered structure similar to that of the first display area, which will not be repeated here.

Please refer to FIG. 5, which is a schematic diagram of a second partial stacking of the display device according to an embodiment of the application. The embodiment of the present application further provides a display device. The display device 20 also comprises a first display area 220 and a second display area 240. The main difference between the display device in this embodiment and the above-mentioned embodiment is that the first display area 220 comprises a first light-emitting layer 222 and a first common electrode layer 224 that are stacked, and the first light-emitting layer 222 comprises a plurality of first pixels 2222. The first common electrode layer 224 comprises an auxiliary conductive portion 2242 and a plurality of first conductive blocks 2244. The auxiliary conductive portion 2242 has a plurality of openings corresponding to the plurality of first pixels 2222, and each opening is provided with a first conductive block 2244. The first conductive block 2244 is adjacent to a first pixel 2222, and the auxiliary conductive portion 2242 is electrically connected to the plurality of first conductive blocks 2244.

The second display area 240 comprises a second light-emitting layer 242 and a second common electrode layer 244. The second light-emitting layer 242 comprises a plurality of second pixels 2422. The second common electrode layer 244 comprises a plurality of second conductive blocks 2444. Two conductive blocks 2444 are adjacent to a second pixel 2422, and the plurality of second conductive blocks 2444 are electrically connected. A thickness of the second conductive block 2444 is greater than a thickness of the first conductive block 2244. The thickness of the first conductive block 2244 is less than that of the second conductive block 2444, the light transmittance of the first conductive block 2244 is greater than the light transmittance of the second conductive block 2444, and the plurality of first conductive blocks 2244 are electrically connected through the auxiliary conductive portion 2242 Therefore, the impedance of the first common electrode layer 224 can be reduced, thereby increasing the transmittance of the first conductive block 2244, and controlling the impedance of the first common electrode layer 224 within an acceptable range. It should be noted that the thickness of the first conductive block 2244 is less than the thickness of the second conductive block 2444, and the impedance (resistance) of the first conductive block 2244 will be greater than the impedance of the second conductive block 2444, resulting in a larger voltage drop than the first conductive block 2244, which is disadvantageous of that the plurality of first conductive blocks 2244 is not conducive to the same or similar voltage. The auxiliary conductive portion 2242 electrically connects the plurality of first conductive blocks 2244, which increases the area of the first common electrode layer 224 and reduces the impedance of the first common electrode layer 224 is reduced, and the voltage drop of the first conductive blocks 2244 at different positions in the first common electrode layer 224 is reduced.

Herein, the first conductive block 2244 needs to cooperate with other components in the area to drive the first pixel 2222, and the auxiliary conductive portion 2242 is used to electrically connect a plurality of first conductive blocks 2244, and can reduce the impedance of the entire first common electrode layer 224. In some embodiments, the material of the auxiliary conductive portion 2242 can be selected from a material with a greater light transmittance than that of the first conductive block 2244, so that the light transmittance of the auxiliary conductive portion 2242 is greater than that of the first conductive block 2244 of the same thickness. At the same time, the light transmittance of the auxiliary conductive portion 2242 and the first conductive block 2244 are both greater than the light transmittance of the second conductive block 2444. In this way, the light transmittance of the first common electrode layer 224 can be made greater than that of the second common electrode layer 244. At the same time, by setting the thickness of the first conductive block 2244 to be less than the thickness of the auxiliary conductive portion 2242, the light transmittance of the entire first common electrode layer 244 is more uniform. Due to the existence of the auxiliary conductive portion 2242, the impedance of the entire first common electrode layer 244 can be lowered, thereby avoiding affecting the driving voltage of the first display area 220 and the display effect of the first display area 220 due to the partial reduction of the thickness of the first common electrode layer 224. For example, the material of the first conductive block 2244 is magnesium metal or silver metal. The auxiliary conductive portion 2242 can be selected from transparent conductive materials such as indium tin oxide (ITO).

Herein, the first conductive block 2244 can be formed by sputtering ultra-thin metal. For example, the first conductive block 2244 is obtained by sputtering ultra-thin metallic magnesium or metallic silver.

The second conductive block may cover the entire second display area. The second conductive block may also be provided only corresponding to the second pixel, and the plurality of second conductive blocks are electrically connected by other wires. As shown in Figure 6. The structure of the first conductive block in the first display area in the embodiment of the present application may adopt the structure of the first common electrode layer in the above-mentioned embodiment, which will not be repeated here.

It should be noted that the material and/or structure of the first conductive block can be the material and structure of the first common electrode layer in any of the above embodiments. The material and/or structure of the auxiliary conductive portion may adopt the material and structure of the auxiliary conductive portion in any of the above embodiments.

The auxiliary conductive portion connected to the plurality of first conductive blocks can be used to reduce the impedance of the entire first common electrode layer. Therefore, the lower the impedance of the auxiliary conductive portion is the better. Herein, a material with a resistivity lower than that of the first conductive block can be selected to form the auxiliary conductive portion, that is, the resistivity of the auxiliary conductive portion is less than that of the first conductive block, and the resistivity of the material of the auxiliary conductive portion is less than that of the first conductive block, which can reduce the impedance of the auxiliary conductive portion, and reduce the impedance of the entire first common electrode layer. Herein, the thickness of the auxiliary conductive portion may be the same as or different from the thickness of the first conductive block.

It is also possible to reduce the impedance of the auxiliary conductive portion by increasing the cross-sectional area of the auxiliary conductive portion. It is difficult to increase the surface area of the auxiliary conductive portion. The cross-sectional area of the auxiliary conductive portion can be increased by increasing the thickness of the auxiliary conductive portion, that is, the thickness of the auxiliary conductive portion is greater than the thickness of the first conductive block, thereby reducing the impedance of the auxiliary conductive portion, and reducing the impedance of the entire first common electrode layer. Herein, the resistivity of the auxiliary conductive portion may be the same as or different from the resistivity of the first conductive block.

It should be noted that in order to reduce the impedance of the auxiliary conductive portion, a material with a smaller resistivity can be selected while increasing the thickness of the auxiliary conductive portion. That is, the resistivity of the auxiliary conductive portion may be less than the resistivity of the first conductive block, while the thickness of the auxiliary conductive portion is greater than the thickness of the first conductive block. On the basis of not changing the impedance of the first conductive block, by reducing the impedance of the auxiliary conductive portion, the impedance of the entire first common electrode layer is reduced as much as possible.

By electrically connecting the first conductive block to the auxiliary conductive portion, the impedance per unit area of the first common electrode layer is approximately equal to the impedance per unit area of the second common electrode layer, and the voltage drop per unit distance between the first common electrode layer and the second common electrode layer is the same or similar, the driving voltage of the first pixel in the first display area and the second pixel in the second display area are not much different, and the impedance per unit area of the second common electrode layer will not be different due to the thickness of the first conductive block is less than that of the second conductive block, which results in different driving voltages of the two.

It should be noted that the thickness of the auxiliary conductive portion may be the same as the thickness of the second conductive block, or may be greater than the thickness of the second conductive block.

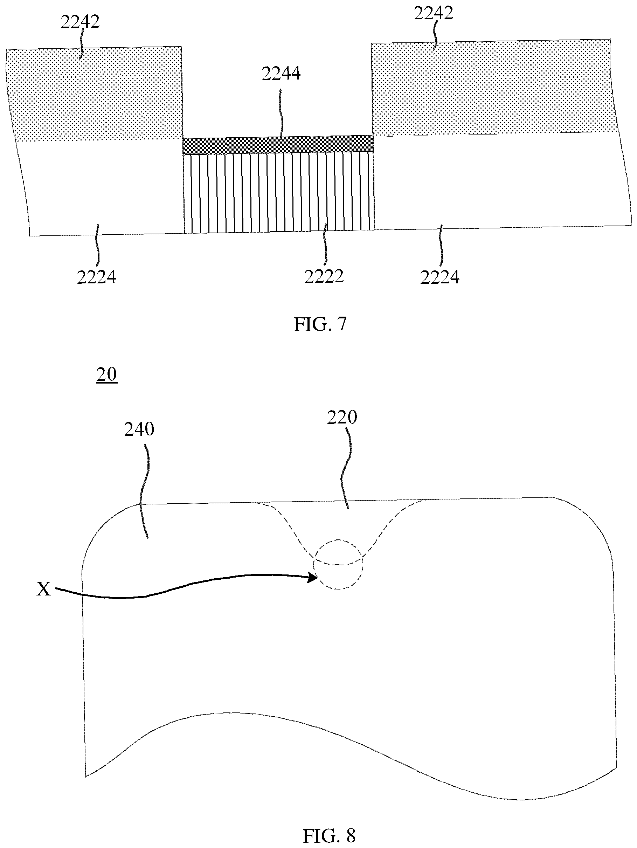

Please refer to FIG. 7, which is a schematic diagram of the laminated structure of the first display area of the display device provided by an embodiment of the application. The first light-emitting layer 222 further comprises a first pixel defining layer 2224. The first pixel defining layer 2224 has a plurality of pixel holes. Each pixel hole is provided with a first pixel 2222. The first conductive block 2244 is arranged in the pixel hole and covers the first pixel 2222. The first conductive block 2244 may be disposed in the pixel hole and cover the first pixel 2222, and the first conductive block 2244 may be well electrically connected with the first pixel 2222.

The auxiliary conductive portion 2242 is adjacent to the first pixel defining layer 2224. It can also be understood that the auxiliary conductive portion 2242 is disposed on the first pixel defining layer 2224. The auxiliary conductive portion 2242 has a first surface adjacent to the first pixel defining layer 2224. A surface of the block 2244 away from the first pixel 2222 is level with the first surface. The first pixel 2222 does not fill the pixel hole. The first conductive block 2244 covers the first pixel 2222 and then fills the pixel hole, and an edge of the first conductive block 2244 is electrically connected to the auxiliary conductive portion 2242.

The first display area may comprise a stacked substrate, a driving circuit layer, an anode layer, a first light-emitting layer, a first common electrode layer, a planarization layer, and the like. Herein, the driving circuit layer, the anode layer and the first common electrode layer jointly drive the first pixel in the first light-emitting layer to emit light and display. The second display area has a layered structure similar to that of the first display area, which will not be repeated here.

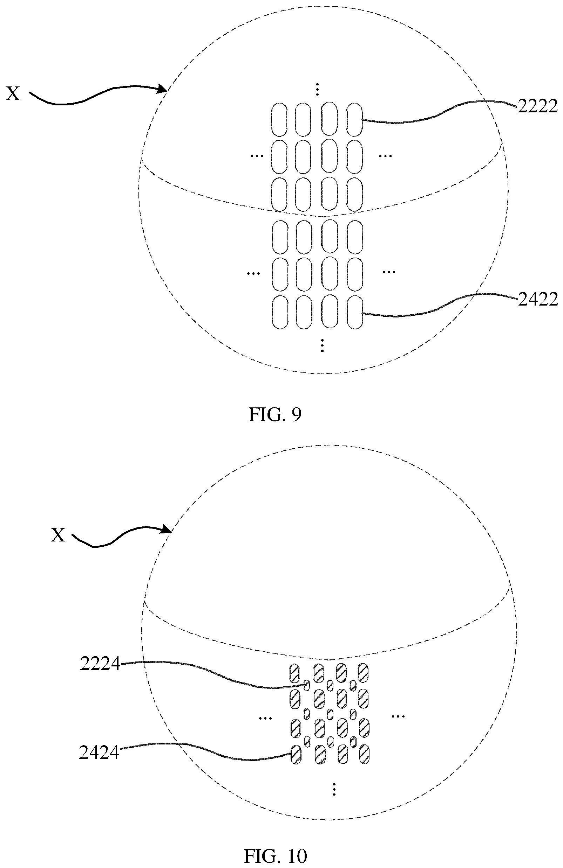

Please refer to FIGs. 8-10. FIG. 8 is a schematic diagram of a portion of the structure of a display device provided by an embodiment of the present application, FIG. 9 is a schematic diagram of a pixel distribution of a portion X of the display device shown in FIG. 8, and FIG. 10 is a schematic diagram of the drive unit distribution of the portion X of the display device shown in FIG. 8. In the display device in any of the above embodiments, the display device further comprises a plurality of first driving units 2224 for driving a plurality of first pixels 2222, and a plurality of second driving units 2424 for driving a plurality of second pixels 2422. The second driving unit 2424 is disposed in the second display area 240. The first driving unit 2224 and the second driving unit 2424 both comprise a plurality of opaque thin film transistors (TFTs), and sensors such as cameras do not need to transmit signals through the second display area 240. Compared with multiple first driving units 2224 is arranged in the first display area 220, and all or at least some of the plurality of first driving units 2224 are arranged in the second display area 240, which can increase the light transmittance of the first display area 220.

Herein, the second driving unit 2424 is disposed in the second display area 240 and is disposed corresponding to the second pixel 2422. For example, each second driving unit 2424 is electrically connected to a second pixel 2422, the second driving unit 2424 is arranged in a one-to-one correspondence with the second pixel 2422, and the second driving unit 2424 is arranged under the second pixel 2422. The size of the second driving unit 2424 varies according to its driving circuit. For example, the second driving unit 2424 may be 7T1C, 5T1C, 2T1C, etc., wherein the larger the number of thin film transistors (TFTs) in the second driving unit 2424, the larger the size thereof. In order to make the display effect of the second display area 240 better, the second driving unit 2424 may be 7T1C, and its size is also the largest, and its size may be similar to the size of the corresponding second pixel 2422.

The first driving unit 2224 may also be disposed in the second display area 240. The first driving unit 2224 may be a simpler driving circuit than the second driving unit 2424. For example, the second driving unit 2424 is 7T1C, and the first driving unit 2224 is 2T1C. The number of thin film transistors included in one first driving unit 2224 is less than the number of thin film transistors included in one second driving unit 2424. The smaller the number of thin film transistors (TFTs) in the first driving unit 2224, the smaller the size thereof, so that the first driving unit 2224 may be disposed between the plurality of second driving units 2424 in the second display area 240. For example, one first driving unit 2224 is provided between two or four second driving units 2424.

The more first driving units 2224 arranged in the second display area 240, the more difficult the process and the higher the cost. In order to meet the optical signal requirements of the camera, the area of the first display area 220 is difficult to shrink. A first driving unit can drive multiple first pixels without changing the area of the first display area 220, the number of first driving units 2224 that drive the plurality of first pixels 2222 is reduced on the premise of not changing the area of the first display area 220 and the number of the first pixels 2222 in the first display area 220, the difficulty of arranging the first driving units 2224 in the second display area 240 is reduced, and the difficulty the process is reduced, and the cost is reduced.

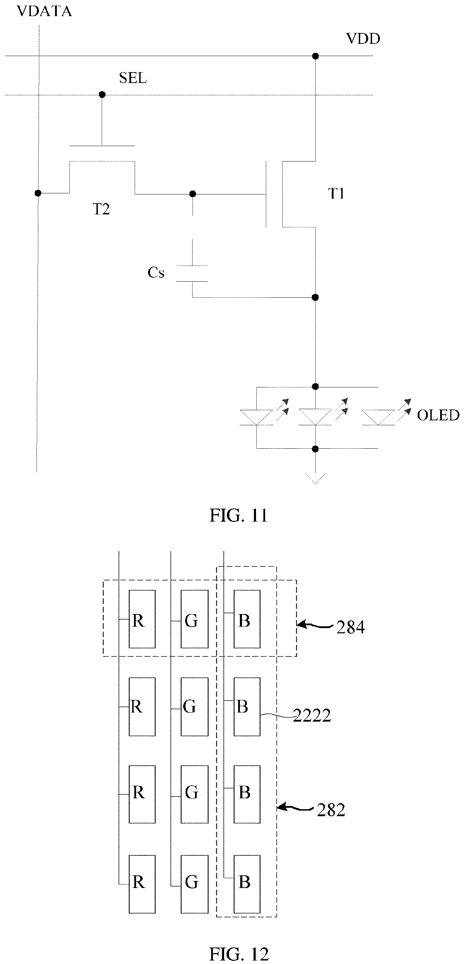

In order to facilitate the understanding of multiple first pixels 2222 in parallel, the first driving unit 2224 of 2T1C is taken as an example for description, as shown in FIG. 11, where VDADA is a data line, SEL can be understood as a gate line, VDD is a power supply line, and the OLED is the first pixel 2222. In the figure, an embodiment in which three first pixels 2222 are connected in parallel is shown. It is understood that other numbers, such as 2, 4, 9, 16, etc, of first pixels 2222 can be connected in parallel according to requirements. It should be noted that the first driving unit 2224 may also be a driving circuit such as 5T1C. The parallel connection of the first pixels 2222 may be formed by the direct connection of the first pixels 2222. For example, the plurality of first pixels 2222 are connected in parallel by the same material as the first pixels or connected in parallel by connection lines of other materials. The parallel connection of the first pixels 2222 may also be connected in parallel in other ways. Specifically, the first display area 220 may further include a plurality of metal anodes. One metal anode is arranged corresponding to and electrically connected to one first pixel 2222, and the parallel connection of the first pixels 2222 can be realized through the parallel connection of the metal anodes.

A plurality of first pixels connected in parallel may form a first pixel set. The multiple first pixels connected in parallel in a first pixel set may be multiple first pixels of the same color. Please refer to FIG. 12, which is a schematic diagram of the structure of the first pixel in the first display area of the display device according to an embodiment of the application. For example, the first pixel set 282 may only comprise a plurality of blue first pixels 2222, that is, a plurality of blue first pixels 2222 are connected in parallel to form a first pixel set 282. Of course, the first pixel set 282 may also only comprise a plurality of red first pixels 2222, and the first pixel set 282 may also only comprise a plurality of green first pixels 2222. The first pixel set 282 may also comprise a plurality of first pixels 2222 of different colors. For example, the first pixel set may comprise red, green, and blue first pixels.

The plurality of first pixels in the first display area may be arranged in a manner of pixel units. The first pixel set 282 can be set according to pixel units. Please continue to refer to FIG. 12, the plurality of first pixels 2222 in the first display area can be divided into a plurality of pixel units 284, the first display area comprises a plurality of pixel units 284, and each pixel unit 284 comprises at least three first pixels 2222 of different colors. One pixel unit 284 in the first display area can be displayed in mixed colors, and one pixel unit 284 can display required colors as needed. For example, one pixel unit 284 comprises first pixels 2222 in three colors of R, G, and B, which can display various colors such as red, green, blue, white, pink, and cyan as required. The first pixels 2222 of the same color of at least two pixel units 284 in the first display area are connected in parallel to form a first pixel set 282. For example, four pixel units 284 can form three first pixel sets 282. Specifically, four red first pixels 2222 are connected in parallel to form a first pixel set 282, and four green first pixels 2222 are connected in parallel to form a first pixel set 282. Four blue first pixels 2222 are connected in parallel to form a first pixel set 282, and the four pixel units 284 form a display unit. The figure shows that one pixel unit 284 comprises first pixels 2222 in three colors of R, G, and B. In some other embodiments, one pixel unit may also comprise first pixels 2222 of multiple colors such as R, G, B, W, or R, G, B, Y, etc.

It is understandable that when one first driving unit drives multiple first pixels connected in parallel, the first driving unit may be all or partially arranged in the second display area, or all of the first driving unit may be arranged in the first display area. The distribution density is small, and the light transmittance of the first display area is also high, which meets the needs of sensors such as cameras.

In order to increase the light transmittance of the first display area, in addition to the above-mentioned embodiments, other methods may also be used. The following describes other methods for improving the light transmittance of the first display area in detail.

Except for the driving circuit layer, all the layer structures in the first display area are made of high light-transmitting materials to increase the light transmittance of the first display area. In addition, the signal lines in the first display area can be made of light-transmitting materials such as ITO or nano-silver. The TFT of the driving circuit layer in the first display area cannot be made of light-transmitting materials, and the driving circuit layer of the first display area may also be made of light-transmitting materials except for TFTs. It can be understood that the solution of increasing the light transmittance of the material and changing the wiring arrangement to increase the first display area is within the scope of the present application.

In order to increase the light transmittance of the first display area, the size of the first pixel in the first display area can be set to be larger than the size of the second pixel in the second display area, and the size of the first pixel in the first display area is larger than the size of the second pixel. The size of the first pixel is positively correlated with the size of the first pixel, that is, the larger the size of the first pixel, the larger the separation distance between the first pixels. Therefore, the distribution density of the first pixel in the first display area is less than the distribution density of the second pixels in the second display area. The light transmittance of the pixel definition layer between the first pixels is greater than the light transmittance of the first pixel. Therefore, the larger the size of the first pixel, the larger the first pixel, and the higher the light transmittance of the display area. For example, the second pixel in the second display area may reach more than 400 ppi, the size of the first pixel in the first display area may be four times that of the second pixel, and the first pixel in the first display area may be 200 ppi.

In order to increase the light transmittance of the first display area, the distribution density of the first pixels can also be set to be less than the distribution density of the second pixels. The size of the first pixel in the first display area is the same as the size of the second pixel. By increasing the separation distance between the first pixels to make the distribution density of the first pixel less than the distribution density of the second pixel. The light transmittance of the pixel definition layer is greater than the light transmittance of the first pixel. Therefore, the smaller the distribution density of the first pixels and the greater the separation distance between the first pixels, the higher the light transmittance of the first display area. Exemplarily, the second pixel in the second display area can reach more than 400 ppi, and the separation distance between the first pixels in the first display area is much larger than the separation distance between the second pixels, so that the first pixels in the first display area are 200 ppi.

Further, by adopting the method of driving the four first pixels in the first display area in parallel provided by the embodiment shown in FIG. 12, the equivalent pixel density of the first display area can be reduced to 100 ppi. At the same time, by arranging all or a portion of the first driving unit of the pip first display area in the second display area, so that the light transmittance of the first display area can be greatly improved.

In some embodiments, in order to increase the light transmittance of the first display area, the first driving unit provided in the first display area may be a simple driving circuit. Specifically, the number of thin film transistors included in the first driving unit may be less than the number of thin film transistors included in the second driving unit. Because thin film transistors do not transmit light, the number of opaque thin film transistors in the first driving unit is small, and they occupy less area, and the opaque area of the driving circuit layer is also less, which improves the transparency of the driving circuit layer. The proportion of the light area increases the light transmittance of the first display area. For example, the second driving unit is a 7T1C driving circuit, and the first driving unit may be a driving circuit such as 5T1C or 2T1C.

In order to allow the second display area to better accommodate the first driving unit, the second display area may comprise a first sub-display area and a second sub-display area, wherein the second sub-display area is connected to the first display through the first sub-display area. The resolution of the first sub-display area is lower than that of the second sub-display area, and the first sub-display area has a larger accommodating space for accommodating the first driving unit.

Specifically, the pixel density of the first sub-display area is less than the pixel density of the second sub-display area, and the density of the second driving circuit driving the first sub-display area is naturally less than the density of the second driving circuit driving the second sub-display area, so there is more accommodating space to accommodate the first drive unit.

The size of the second pixel in the first sub-display area may be larger than the size of the second pixel in the second sub-display area, the spacing between the second pixels is proportional to the size of the second pixel, and the size of the second driving unit remains unchanged. The space outside the second driving unit in the driving circuit layer becomes larger, so that the first driving unit can be accommodated. The size of the second pixel in the first sub-display area may be equal to the size of the second pixel in the second sub-display area, and the pitch of the second pixel in the first sub-display area may be greater than the pitch of the second pixel in the second sub-display area, and has a larger space to accommodate the first drive unit.

In some other embodiments, the first sub-display area comprises a plurality of second pixel sets and a plurality of second driving units, and each of the second pixel sets comprises at least two second pixels connected in parallel with each other. All the second pixels in the second pixel set are electrically connected to a second driving unit. The multiple second pixels parallel to each other are equivalent to one display dot, which reduces the resolution of the first sub-display area. For the specific structure of the second pixel set, please refer to the structure of the first pixel set in the above embodiment, which will not be repeated here.

The display device may further include a polarizer, and the polarizer may have a first polarizing portion corresponding to the first display area, and the first polarizing portion may be a through hole or a light-transmitting material. For example, a through hole is first provided corresponding to the first display area, and then a transparent material is filled in the through hole to form the first polarizing portion. For another example, first set a through hole corresponding to the first display area, and then fill the through hole with a material with high light transmittance and low polarization to form the first polarizing portion, so that the first polarizing portion can not only achieve the function of high light transmittance, but also prevent the light from reflecting out, allowing users to see the function of the internal structure.

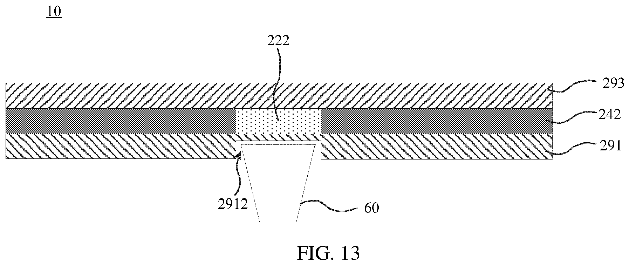

The lens of the camera in the electronic equipment faces the substrate of the display device, and the camera is used form image by obtain external light signals passing through the first display area. In order to reduce the space occupied by the camera, the lens of the camera can be close to or adjacent to the substrate of the display device. The substrate of the display device is mainly used to carry other layer structures of the display device, and does not need special functions. In order to further reduce the space occupied by the camera, the camera portion can be arranged in the substrate. Please refer to FIG. 13 for details. FIG. 13 is another structural schematic diagram of the electronic device according to an embodiment of the application. The electronic device 10 comprises a display device and a camera 60. The display device comprises a substrate 291 and a cover plate 293 disposed opposite to each other. A first light-emitting layer 222 and a second light-emitting layer 242 are provided between the substrate 291 and the cover plate 293. The first light-emitting layer 222 corresponds to the first display area, and the second light-emitting layer 242 corresponds to the second display area. A first mounting hole 2912 is provided at a position of the substrate 291 relative to the camera 60, and the camera 60 is at least partially disposed in the first mounting hole 2912. The first mounting hole 2912 may be a blind hole, that is, the thickness of the portion of the substrate 291 relative to the camera 60 is less than the thickness of other portions. The substrate 291 is still a complete substrate 291, which does not affect its function of carrying other layer structures of the display device 20, and can be vacant portion of the space accommodates the camera 60. The installation manner of the first mounting hole 2912 and the camera 60 can be set according to the size of the first mounting hole 2912 and the size of the camera 60. Exemplarily, if the space of the first mounting hole 2912 is insufficient to install the entire camera 60, the lens 62 of the camera 60 is partially disposed in the first mounting hole. If the camera 60 is sufficiently small, the entire camera 60 is set in the first mounting hole 2912.

It should be noted that the camera 60 relative to the first display area 220 can be used as the front camera 60 of the electronic device. The front camera is generally a camera with a lens that cannot be moved. The substrate 291 of the display device can be provided with a first mounting hole. The camera 60 of a display area 220 may be a camera 60 with a movable lens 62, and the lens 62 of the camera 60 may be movable for realizing functions such as auto-focusing.

In some other embodiments, the first driving unit for driving the first pixel in the first light-emitting layer may all be arranged in the second display area, the driving circuit layer of the first display area may not be provided with the first driving unit, and the first mounting hole may be a through hole, the driving circuit layer of the first display area is provided with a second mounting hole corresponding to the first mounting hole, and the second mounting hole is communicated with the first mounting hole.

It can be understood that, in any of the above embodiments, the size and shape of the first pixel in the first display area can be set as required. For example, the first pixel may be rectangular or similar to circular. The circular-like first pixel may be a circle, an ellipse, a rounded rectangle, or the like. Since the edge of the first pixel that is similar to the circle is an arc-shaped transition, the diffraction problem in the first display area can be improved.

The display device may have a regular shape, such as a rectangle, a rounded rectangle, or a circle. Of course, in some other possible embodiments, the display device may also have an irregular shape, which is not limited in the embodiment of the present application.

One camera or multiple cameras can be set under the first display area. Multiple cameras can be cameras that cooperate with each other, such as two identical cameras, a normal camera, and a virtual camera or a black-and-white camera. Below the first display area, in addition to the camera, other functional devices, such as proximity sensors, light sensor, distance measuring sensor, fingerprint recognition sensor, etc. can also be set.

In order to have a better understanding of the electronic devices in the embodiments of the present application. The structure of the electronic device is further explained below. Please continue to refer to FIG. 1, the electronic device 10 further comprises a housing 40 and a camera 60.

The housing 40 may comprise a back cover (not shown in the figure) and a frame 420, and the frame 420 is arranged around the periphery of the back cover. The display device 20 may be disposed in the frame 420, and the display device 20 and the back cover may be used as two opposite sides of the electronic device 10. The camera 60 is provided between the back cover of the housing 40 and the display device 20. The display device 20 may be an organic light-emitting diode (OLED) display device 20. The display device 20 may be a full screen, that is, the display surface of the display device 20 is basically a display area. The display device 20 may also be provided with a cover plate. The cover plate covers the display device 20 to protect the display device 20 and prevent the display device 20 from being scratched or damaged by water. Herein, the cover plate may be a transparent glass cover plate, so that the user can observe the information displayed by the display device 20 through the cover plate. For example, the cover plate may be a cover plate made of sapphire.

The electronic device can also comprise circuit boards, batteries, and midplanes. The frame 420 is arranged around the middle board, wherein the frame 420 and the middle board may form a middle frame of the electronic device 10. The middle board and the frame 420 form an accommodating cavity on both sides of the middle board. One accommodating cavity is used for accommodating the display device 20, and the other accommodating cavity is used for accommodating circuit boards, batteries, and other electronic components or functions of the electronic device 10.

Among them, the middle plate may have a thin plate or sheet-like structure, or a hollow frame structure. The middle frame is used to provide support for the electronic components or functional components in the electronic device 10 so as to install the electronic components and functional components in the electronic device 10 together. The camera 60, receiver, battery and other functional components of the electronic device 10 can all be mounted on the middle frame or circuit board for fixing. It is understandable that the material of the middle frame may comprise metal or plastic.

The circuit board can be installed on the middle frame. The circuit board may be the main board of the electronic device 10. Herein, the circuit board may be integrated with one or more of functional components such as a microphone, a speaker, a receiver, a headphone interface, an acceleration sensor, a gyroscope, and a processor. At the same time, the display device 20 may be electrically connected to the circuit board to control the display of the display device 20 through a processor on the circuit board. The display device 20 and the camera 60 may both be electrically connected to the processor; when the processor receives a shooting instruction, the processor controls the first display area to turn off the display, and controls the camera 60 to collect images through the first display area 220. When the camera does not receive a shooting instruction and receives an image display instruction, the processor controls the first display area 220 and the second display area 240 to display images together.

The battery can be installed on the middle frame. At the same time, the battery is electrically connected to the circuit board, so that the battery can supply power to the electronic device 10. Herein, a power management circuit can be provided on the circuit board. The power management circuit is used to distribute the voltage provided by the battery to various electronic components in the electronic device 10.

It should be understood that the "plurality" mentioned herein refers to two or more.

The display device and electronic device provided in the embodiments of the present application have been described in detail above. Specific examples are used in this article to describe the principle and implementation of the application, and the description of the above examples is only used to help understand the application. At the same time, for those skilled in the art, according to the idea of the application, there will be changes in the specific implementation and the scope of application. In summary, the content of this specification should not be construed as a limitation to the application.

## Claims

1. A display device, comprising:
a first display area, wherein the first display area comprises a first common electrode layer and a first light-emitting layer, and the first common electrode layer covers the first light-emitting layer; and
a second display area, wherein the second display area comprises a second common electrode layer and a second light-emitting layer, the second common electrode layer covers the second light-emitting layer, and a thickness of the second common electrode layer is greater than a thickness of the first common electrode;
wherein the first display area further comprises an auxiliary conductive portion, the auxiliary conductive portion is disposed on a side of the first common electrode layer away from the first light-emitting layer, the first light-emitting layer comprises a plurality of first pixels, an orthographic projection of the auxiliary conductive portion on the light-emitting layer is located between the plurality of first pixels, and the auxiliary conductive portion is electrically connected to the first common electrode layer.

2. The display device according to claim 1, wherein a light transmittance of the auxiliary conductive portion is greater than a light transmittance of the first common electrode layer.

3. The display device according to claim 1, wherein a thickness of the auxiliary conductive portion is greater than a thickness of the first common electrode layer; and/or a resistivity of the auxiliary conductive portion is less than a resistivity of the first common electrode layer.

4. The display device according to claim 1, wherein the first common electrode layer comprises at least a first metal layer, a second metal layer, and a third metal layer that are stacked, and a material of the first metal layer is different from a material of the second metal layer, and the material of the second metal layer is different from a material of the third metal layer.

5. The display device according to claim 4, wherein the material of the first metal layer and the third metal layer is both metallic magnesium, and the material of the second metal layer is metallic silver.

6. The display device according to claim 1, wherein the first common electrode layer and the auxiliary conductive portion have a first impedance per unit area after being electrically connected, the second common electrode layer has a second impedance per unit area, and the first impedance is less than or equal to the second impedance.

7. The display device according to claim 1, wherein the display device further comprises a plurality of first driving units for driving the plurality of the first pixels, and at least some of the plurality of first driving units are disposed in the second display area.

8. The display device according to claim 7, wherein the first display area comprises a plurality of first pixel sets, each of the first pixel sets comprises at least two of the first pixels connected in parallel with each other, and all the first pixels in each of the first pixel sets are electrically connected to the first driving unit.

9. The display device according to claim 7, wherein the second display area comprises a first sub-display area and a second sub-display area, and the second sub-display area is connected to the first display area through the first sub-display area, a resolution of the first sub-display area is lower than a resolution of the second sub-display area.

10. The display device according to claim 9, wherein a pixel density of the first sub-display area is less than a pixel density of the second sub-display area.

11. The display device according to claim 9, wherein the first sub-display area comprises a plurality of second pixel sets and a plurality of second driving units, and each of the second pixel sets comprises at least two of the second pixels connected in parallel with each other, and all the second pixels in each of the second pixel sets are electrically connected to the second driving unit.

12. A display device, comprising:
a first display area, wherein the first display area comprises a first light-emitting layer and a first common electrode layer that are stacked, the first light-emitting layer comprises a plurality of first pixels, the first common electrode layer comprises an auxiliary conductive portion and a plurality of first conductive blocks, the auxiliary conductive portion has a plurality of openings corresponding to the plurality of first pixels, each of the openings is provided with the first conductive block, each of the first conductive blocks is adjacent to the first pixel, and the auxiliary conductive portion is electrically connected to a plurality of the first conductive blocks; and
a second display area, wherein the second display area comprises a second light-emitting layer and a second common electrode layer, the second light-emitting layer comprises a plurality of second pixels, the second common electrode layer comprises a plurality of second conductive blocks, each of the second conductive blocks is adjacent to a second pixel, the plurality of the second conductive blocks are electrically connected, and a thickness of the second conductive blocks is greater than a thickness of the first conductive blocks.

13. The display device according to claim 12, wherein a light transmittance of the auxiliary conductive portion is greater than a light transmittance of the first conductive blocks.

14. The display device according to claim 12, wherein a thickness of the auxiliary conductive portion is greater than a thickness of the first common electrode layer; and/or a resistivity of the auxiliary conductive portion is less than a resistivity of the first conductive blocks.

15. The display device according to claim 12, wherein an impedance per unit area of the first common electrode layer is less than or equal to an impedance per unit area of the second impedance.

16. The display device according to claim 12, wherein the first light-emitting layer further comprises a first pixel definition layer, the first pixel definition layer has a plurality of pixel holes, and each pixel hole is provided with the first pixel, and the first conductive block is arranged in the pixel hole and covers the first pixel.

17. The display device according to claim 16, wherein the auxiliary conductive portion is adjacent to the first pixel defining layer, the auxiliary conductive portion has a first surface adjacent to the first pixel defining layer, and a surface of the block facing away from the first pixel is level with the first surface.

18. The display device according to claim 12, wherein the display device further comprises a plurality of first driving units for driving the plurality of the first pixels, and at least some of the plurality of first driving units are disposed in the second display area.

19. The display device according to claim 18, wherein the first display area comprises a plurality of first pixel sets, each of the first pixel sets comprises at least two of the first pixels connected in parallel with each other, and all the first pixels in each of the first pixel sets are electrically connected to the first driving unit.

20. The display device according to claim 18, wherein the second display area comprises a first sub-display area and a second sub-display area, and the second sub-display area is connected to the first display area through the first sub-display area, a resolution of the first sub-display area is lower than a resolution of the second sub-display area.

21. An electronic device, comprising:
a display device, wherein the display device is the display device according to any one of claims 1-20;
a camera, wherein the camera comprises a lens, the lens is disposed toward the first display area, and the camera is used to form an image by obtaining an external light signal passing through the first display area.
